# EUROPEAN PATENT APPLICATION

(11) **EP 2 072 643 A1**
(43) Date of publication of application: **24.06.2009**
(21) Application number: 07828300.9
(22) Date of filing: 21.09.2007
(51) Int. Cl.: C25D 5/00, C25D 7/12

(54) **ELECTROPLATING METHOD**

(30) Priority: 02.10.2006 JP 2006270762
(71) Applicant: S.E.S. Company Limited, Ome-shi, Tokyo 198-0023 (JP); Miyata, Seizo, Nishitokyo-shi, Tokyo 202-0004 (JP)
(72) Inventor: MIYATA, Seizo, Nishitokyo-shi Tokyo 2020004 (JP); SHIMIZU, Tetsuyac/o S.E.S. CO., LTD. Research, Saitama;3580035 (JP); TAJIMA, Hisayoshic/o S.E.S. CO., LTD., Saitama;3580035 (JP); SONE, Masato, Tokyo, 1840004 (JP)
(74) Representative: HOFFMANN EITLE
(86) International application number: PCT/JP2007/068380
(87) International publication number: WO 2008/041516

(57) **Abstract**

The surface of a metal base is electroplated by utilizing an induction codeposition phenomenon using at least one of carbon dioxide and inert gas, an electroplating liquid containing a metal powder dispersed therein, and a surfactant in a supercritical state or a subcritical state. The concentration of the metal in the electroplating liquid is in a saturated or supersaturated state. Accordingly, the dissolution speed of the metal base can be suppressed, and, at the same time, a plating layer having a smooth surface can be formed in a short time by utilizing an induction codeposition phenomenon. The electroplating method can be applied even when the metal base is formed of a metallic thin film provided on a surface of an insulating film provided on the substrate, or even when the metal is copper, zinc, iron, nickel, or cobalt. The above constitution can provide an electroplating method which, in electroplating on the surface of a metal base, can prevent the dissolution of the metal base to realize normal electroplating even in the case of a very thin metal base.

## Description

### TECHNICAL FIELD

The present invention relates to an electroplating method for electroplating the surface of a metal base, and particularly relates to an electroplating method in which the dissolution of the metal base that has not yet been electroplated can be prevented, and a uniform film can be obtained by electroplating in a short time using an induction codeposition phenomenon even on a very thin metal base.

### BACKGROUND ART

In conventional methods for forming a fine metal wiring within a semiconductor element, a thin aluminum film is first formed, for example, on a substrate by sputtering; a photoresist is then applied; a pattern is formed by exposure and development; and a designated wiring is formed by etching. However, such wiring methods have come to be difficult to use with the progress in the increased integration and miniaturization of semiconductor circuit elements, prompting wider use of so-called Damascene methods, in which a wiring groove or hole is formed in advance; aluminum is embedded in the groove or hole by chemical vapor deposition (CVD), sputtering, plating, or another method; and the surface is then polished by chemical mechanical polishing (CMP) to form a wiring. One of the Damascene methods, referred to as the dual Damascene method, is one in which a hole for connecting the bottom layer to the wiring is formed at the time the groove is formed, the connecting hole and groove are filled with aluminum or copper at the same time, and a wiring is formed.

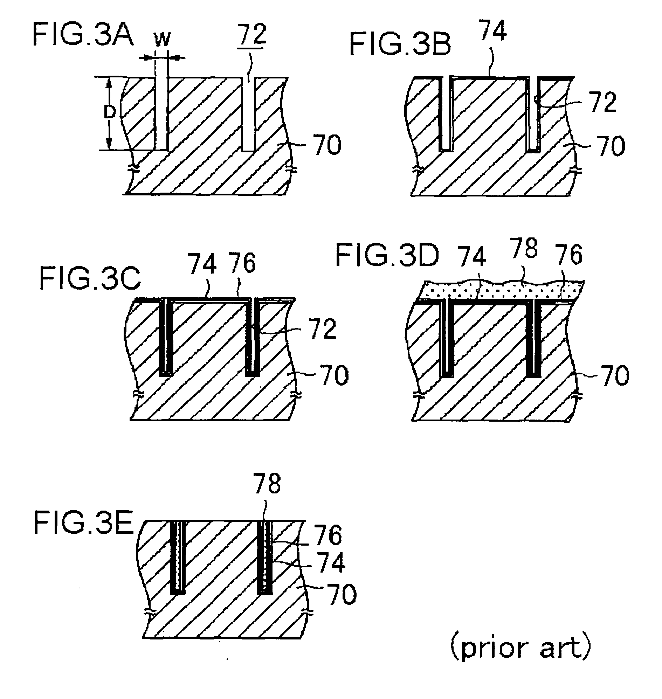

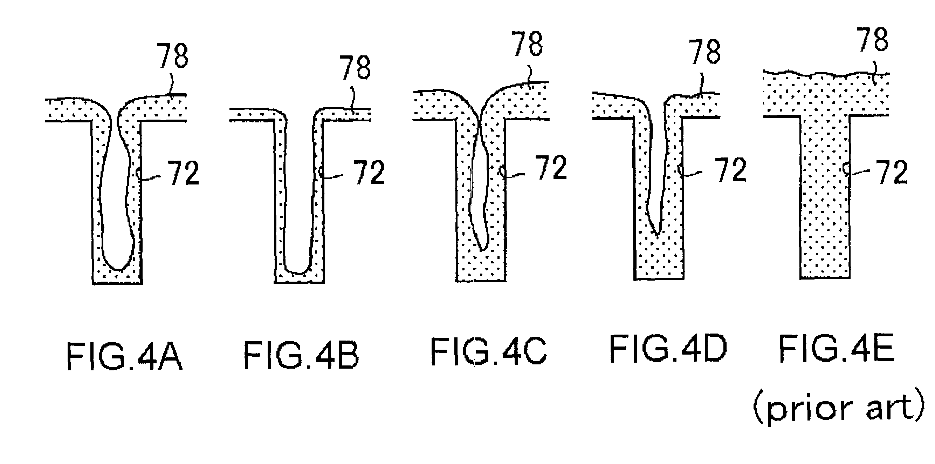

A Damascene method in which electroplating is used has recently become popular as a step for forming wiring in a semiconductor device (see Patent Documents 1 and 2 below). Following is a description, made with reference to FIGS. 3 and 4, of a method for forming a wiring in a semiconductor device for three-dimensional mounting by using the Damascene method disclosed as a prior-art example in Patent Document 1. In this wiring method, a hole 72 is formed by, for example, lithography or etching in the surface of a silicon substrate or other substrate 70, as shown in FIG. 3A; an insulating film 74 composed of SiO₂ is subsequently formed by, for example, CVD on the surface of the substrate 70, as shown in FIG. 3B; the surface of the hole 72 is covered with the insulating film 74 to thereby prevent leakage of electricity; and a seed layer 76 is further formed by, for example, CVD or sputtering as an electroplating feeder layer on the insulating film 74, as shown in FIG. 3C.

The surface of the substrate 70 is electroplated with copper as shown in FIG. 3D, the interior of the hole 72 in the substrate 70 is filled with copper, a copper plating film 78 is deposited on the insulating film 74, the copper plating film 78 and the insulating film 74 are then removed from the substrate 70 by CMP as shown in FIG. 3E, and the surface of the copper plating film 78 in the hole 72 is made substantially coplanar with the surface of the substrate 70 to form an embedded wiring.

In the embedded wiring disclosed in Patent Document 1, the diameter W of the hole 72 is about 5 to 20 µm, and the wiring is applicable to cases in which the depth D is about 50 to 70 µm. In the step in which copper is electroplated in the manner shown in FIG. 3D according to the invention disclosed in Patent Document 1, a step is added in which part of the plating film is etched during the electroplating step, as shown in FIG. 4B, in order to prevent situations in which the copper creates an overhang in proximity to the entrance to the hole 72, as shown in FIG. 4A, and voids (air holes) are formed inside the copper wiring. The groove 72 is filled with copper 78, as shown in FIG. 4E, by further repeating the electroplating step and the plating film etching step the desired number of times, as shown in FIGS. 4C and 4D.

Thus, using inventions such as the one disclosed in Patent Document 1 makes it difficult to fill copper without voids into a narrow groove or hole that measures about 0.20 µm or less. Therefore, this problem is solved in the invention disclosed in Patent Document 2 below by adjusting the composition of the plating solution and adjusting the metal deposition rate at the bottom and entrance of the groove or hole.

Patent Document 1: Japanese Laid-Open Patent Application No. 2003-96596 (claims; paragraphs [0003] to [0010], [0011]; FIGS. 4, 6, 8)
Patent Document 2: Japanese Laid-Open Patent Application No. 2005-259959 (claims; paragraphs [0011], [0013], [0029]; FIGS. 1 and 2)
Patent Document 3: Japanese Laid-Open Patent Application No. 2003-321798 (paragraphs [0001] to [0009])
Patent Document 4: Japanese Laid-Open Patent Application No. 2005-154816 (claim 15, paragraphs [0023] to [0036], FIG. 1)
Patent Document 5: Japanese Laid-Open Patent Application No. 7-268696 (claims; paragraphs [0021] to [0022]; FIGS. 1 and 2)

### DISCLOSURE OF THE INVENTION

### [Problems the Invention Is Intended to Solve]

As described above, in the Damascene method or the dual Damascene method, a seed layer, namely, a very thin metal base, is formed on the surface of the insulating film as an electroplated feed layer by CVD or sputtering, and a similar metal is also electroplated onto the surface of the metal base. Our experiments showed, however, that when this metal base was immersed into an electroplating solution to electroplate a similar metal, the metal base was often dissolved even if the metal base was a thick plate, and the plating failed without producing a smooth, normal surface. Such a phenomenon can be clearly observed in particular in the case of an electroplating method (see Patent Documents 3 and 4 above) conducted using a supercritical fluid or subcritical fluid in which the metal base has a high dissolution rate.

As a result of repeated experiments conducted on the premise that plating failures such as those described above could be suppressed if the dissolution of the metal base in the electroplating solution could be reduced, the inventors completed the present invention upon discovering that by adding a powdered plating metal to the electroplating solution in advance in an amount equal to or greater than the amount (solubility) at which the plating metal could no longer be dissolved, stirring the solution to supersaturation, and performing other operations, the powdered plating metal is dispersed into the electroplating solution, and the metal is electroplated in a dispersed state, whereupon electroplating could be performed in a regular manner and a uniform film could be obtained in a short time by using an induction codeposition phenomenon because the metal base did not readily dissolve in the electroplating solution even if the metal base was immersed into the electroplating solution.

Namely, an object of the present invention is to provide an electroplating method wherein dissolution of the metal base prior to electroplating can be prevented; the electrode, i.e., the not yet electrodeposited metal base, can be prevented from dissolving; and a uniform film can be obtained by electroplating in a short time by using the induction codeposition phenomenon even if the metal base is very thin.

Patent Document 5 discloses an invention wherein granular or pulverulent nickel is directly added into a dissolution bath in order to adjust the concentration of nickel in a nickel plating solution, but no description of an electroplating bath is given, and it is clear that the resulting nickel plating solution is fed to a separate electroplating bath to perform electroplating.

### [Means for Solving the Abovementioned Problems]

Aimed at achieving the aforementioned object, the electroplating method of the present invention is a method for electroplating the surface of a metal base, the method characterized in comprising: performing electroplating by utilizing the induction codeposition phenomenon in a supercritical or a subcritical state using at least one of carbon dioxide and an inert gas, as well as an electroplating solution containing a metal powder dispersed therein, and a surfactant. In the present specification, "induction codeposition phenomenon" refers to a phenomenon in which a portion of metal powder is also simultaneously incorporated into the plating film during electroplating.

The electroplating method of the present invention is also **characterized in that** the metal powder comprises the same metal as at least one of the metal base and a metal film obtained in electroplating.

The electroplating method of the present invention is also **characterized in that** the average particle diameter of the abovementioned metal powder is from 1 µm or greater to 100 µm or less.

The abovementioned electroplating method of the present invention is **characterized in that** the average particle diameter of the metal powder is from 1 nm or greater to less than 1 µm.

The electroplating method of the present invention is also **characterized in that** a voltage at which the metal base does not dissolve is applied before the metal base is immersed into the electroplating solution.

The electroplating method of the present invention is also **characterized in that** the voltage at which the metal base does not dissolve is the voltage used during electroplating.

### [Effect of the Invention]

By adopting a method such as the one described above, the present invention provides excellent effects as described hereinafter. In other words, when the surface of a metal base is electroplated according to the electroplating method of the present invention, the electroplating solution and the metal base are in contact with each other in an emulsion state because an arrangement is adopted in which electroplating is performed by utilizing the induction codeposition phenomenon using at least one of a carbon dioxide and an inert gas, as well as an electroplating solution containing a metal powder dispersed therein, and a surfactant in a supercritical or a subcritical state. For this reason, the electroplating solution rapidly penetrates into fine holes and grooves, and even a metal base having a complex shape can therefore be effectively electroplated in applications in which fine metal wiring is formed in highly integrated, miniaturized semiconductor circuit elements.

According to the electroplating method of the present invention, electroplating is performed in a state in which the metal powder is dispersed in the electroplating solution, and the concentration of the metal in the electroplating solution therefore corresponds to a saturated or supersaturated state. Therefore, the dissolution rate of the metal base can be reduced when the metal base is immersed into the electroplating solution, and a uniform film can be obtained by electroplating in a short time by using the induction codeposition phenomenon.

According to the electroplating method of the present invention, the dissolution rate of the metal base can be reduced when the metal base is immersed into the electroplating solution, for which reason electroplating can be performed in the regular manner even if the metal base is a thin metal film formed on the surface of an insulating film provided on a substrate. In particular, effective use can be made of the method in a Damascene method, dual Damascene method, or other application in which fine wiring is formed in miniaturized semiconductor circuit elements.

According to the electroplating method of the present invention, because the average particle diameter of the metal powder is set within a range of from 1 µm or greater to 100 µm or less and the solubility of metal powder in the electrolytic solution is high, metal ions can be efficiently fed to the electrolytic solution. In this case, the substrate microstructure to be deposited must be precise to 1 µm or more. An average particle diameter of the metal powder exceeding 100 µm is not preferred because the dissolution rate of the metal powder will be low.

According to the electroplating method of the present invention, the average particle diameter of the metal powder is set within a range of from 1 nm or greater to less than 1 µm. Therefore, the metal powder can be easily dispersed into the electrolytic solution, not only making aggregation more difficult, but also facilitating electroplating in microstructures having a precision of less than 1 µm.

The present invention is particularly suited for applications involving formation of fine wiring. The reason is that because a voltage at which the metal base will not dissolve is applied before the metal base is immersed into the electroplating solution, the metal base will not dissolve even if the metal base is immersed into the electroplating solution, and the voltage required for electroplating can be applied once a sufficiently stable state is established after the metal base has been immersed into the electroplating solution.

According to the present invention, because the electroplating voltage is applied before the metal base is immersed into the electroplating solution, the surface of the metal base is electroplated immediately after the metal base is immersed into the electroplating solution, and the designated electroplating layer can therefore be obtained in a short time.

### BRIEF DESCRIPTION OF THE DRAWINGS

FIG. 1 is a schematic view of an electroplating device used in the experimental examples;
FIG. 2 is a view showing the relationship between the amount of copper dissolved from an electrolytic copper sample and the elapsed time;
FIG. 3A through 3E are views showing steps for forming a wiring in a semiconductor device for three-dimensional mounting in a prior-art example; and
FIG. 4 is a view showing the void suppression step employed by the prior art shown in FIG. 3.

### [Key to Symbols]

- 10: electroplating device
- 11: pressure-resistant electroplating chamber
- 12: carbon dioxide cylinder
- 13: high-pressure pump unit
- 14: valve
- 15: lid
- 16: entrance
- 17: exit
- 18: pressure adjustment unit
- 19: electroplating solution
- 20: stirrer
- 21: oven
- 22: metal base sample
- 23: counter electrode
- 24: direct current power source

### BEST MODE FOR CARRYING OUT THE INVENTION

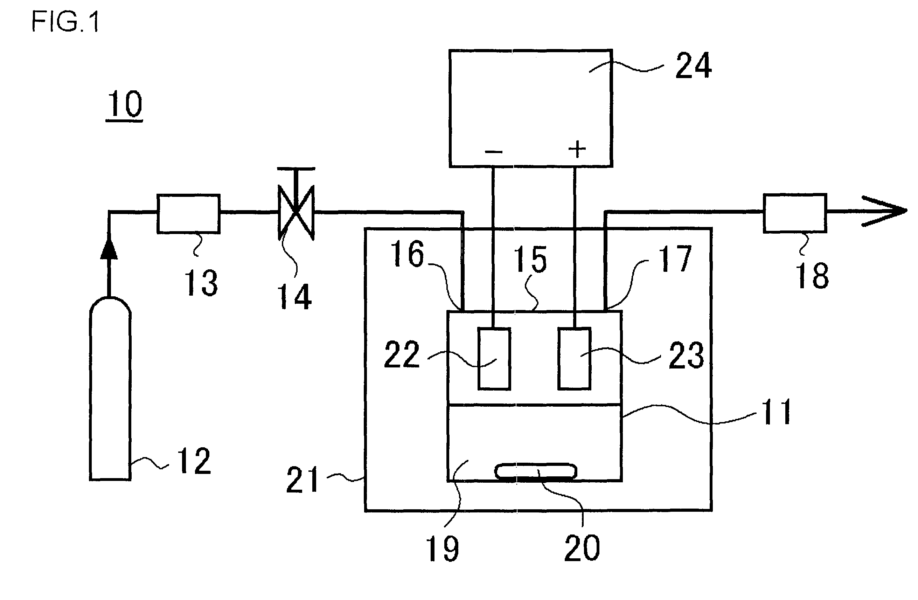

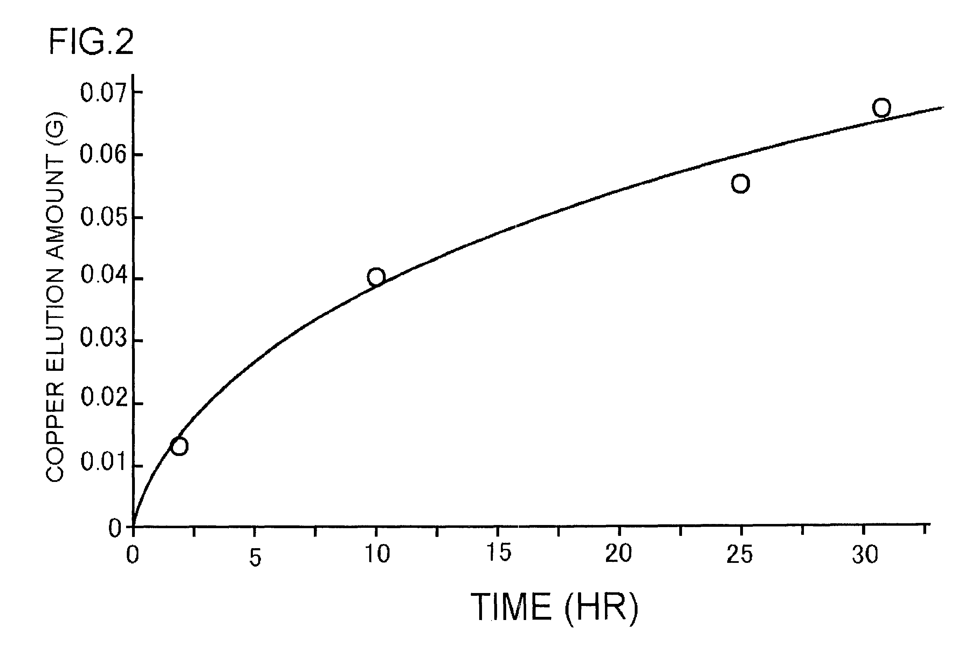

Preferred embodiments for implementing the present invention will be described in detail hereinafter with reference to the experimental examples and the drawings, but the experimental examples described below are not intended to limit the present invention to those described herein, and the present invention is equally applicable to various modifications that do not depart from the technical spirit described in the claims. FIG. 1 is a schematic view of an electroplating device used in the experimental examples, and FIG. 2 is a view showing the relationship between the amount of copper dissolved from an electrolytic copper sample and the elapsed time.

### [Electroplating Solution]

Described below are the composition of the electroplating solution for copper applications that was used in the experimental examples, and the constitution of the experimental system.

### Electroplating solution composition

| | |
|---|---|
| Copper sulfate (CuSo₄ • 5H₂O) | 70 g/L |
| Sulfuric acid (H₂SO₄) | 180 g/L |
| Chlorine ions (Cl⁻) | 50 mg/L |
| Nonionic surfactant | 10 mL/L |

Hereinafter, an electroplating solution for copper having the abovementioned composition is referred to as a "high-throw bath."

### [Electroplating Apparatus]

A pressure-resistant electroplating chamber 11 was used in an electroplating apparatus 10 in order to be able to perform electroplating using a supercritical fluid or subcritical fluid, as shown in FIG. 1. Carbon dioxide can be fed as necessary from a carbon dioxide cylinder 12 through a high-pressure pump unit 13 and a valve 14 to the entrance 16 provided in a cover 15 on the upper part of the pressure-resistant electroplating chamber 11. The carbon dioxide can also be released into the surrounding atmosphere through a pressure adjustment unit 18 from an exit 17 provided in the cover 15 on the upper part.

Removing the cover 15 of the pressure-resistant electroplating chamber 11 allows a predetermined amount of an electroplating solution 19 to be injected into the chamber, and a stirrer 20 is inserted as stirring means into the pressure-resistant electroplating chamber 11. The pressure-resistant electroplating chamber 11 is configured so as to be placed inside an oven 21 and to allow the electroplating solution 19 inside the chamber to be kept at a constant temperature.

A metal base sample 22 and a counter electrode 23 are electrically insulated and placed in the upper part of the pressure-resistant electroplating chamber 11.
The metal base sample 22 is electrically connected to the negative terminal of a direct current power source 24, and the counter electrode 23 is connected to the positive terminal of the direct current power source 24. A copper plate or a thin copper film formed on the surface of TaN film is used in the experimental examples, examples, and the like described hereinafter; and commercial-grade high phosphorous copper is used as the counter electrode.

To conduct an experiment in a supercritical or subcritical state in the electroplating apparatus 10, the carbon dioxide cylinder 12, the high-pressure pump unit 13, the valve 14, and the pressure adjustment unit 18 were operated to maintain the pressure in the pressure-resistant electroplating chamber 11 at 8 to 10 MPa; the oven 21 was operated to heat the electroplating solution 19 to 40°C; and a supercritical or a subcritical state was created inside the pressure-resistant electroplating chamber 11. To conduct an experiment under one atmosphere of pressure, the carbon dioxide cylinder 12, the high-pressure pump unit 13, the valve 14, and the pressure adjustment unit 18 were operated to open the interior of the pressure-resistant electroplating chamber 11 to atmospheric pressure, and the oven 21 was operated to heat the electroplating solution 19 to a designated temperature.

### [Experimental Example 1 through 3]

In Experimental Examples 1 through 3, the solubility of the metal base was investigated when electroplating was conducted in a supercritical state using the high-throw bath. A base obtained by forming a thin copper film having a thickness of 65 nm on a TaN film by sputtering was used as the metal base sample 22. This metal base sample 22 was pretreated by acid pickling and placed together with the counter electrode 23 in the upper part of the electroplating solution 19 in the pressure-resistant plating chamber 11 to as not to be in contact with the electroplating solution 19. The amount of the electroplating solution 19 used was set at 30 mL.

In this state, the electroplating solution in the pressure-resistant electroplating chamber 11 was heated to a temperature of 40°C; the electroplating solution 19 was not stirred by the stirrer 20; and the carbon dioxide cylinder 12, the high-pressure pump unit 13, the valve 14, and the pressure adjustment unit 18 were operated to increase the pressure inside the pressure-resistant electroplating chamber 11 to 10 MPa. The electroplating solution 19 was stirred by the stirrer 20 at the same time as the pressure inside the pressure-resistant electroplating chamber 11 reached 10 MPa.

When this was done, the critical pressure of the carbon dioxide was about 7.38 MPa when the temperature of the electroplating solution 19 was 40°C. Therefore, the interior of the pressure-resistant electroplating chamber 11 was substantially in a supercritical or a subcritical state under the abovementioned temperature and pressure conditions, the electroplating solution 19 was substantially emulsified by the presence of the surfactant in the electroplating solution 19, and the electroplating solution 19 in the emulsion state was poured into the pressure-resistant electroplating chamber 11 and brought into adequate contact with the metal base sample 22 and the counter electrode 23.

The plating state on the surface of the metal base sample 22 was then investigated under the following three conditions.
Experimental Example 1: Five minutes after the pressure inside the pressure-resistant electroplating chamber 11 became 10 MPa, an electroplating voltage was applied between the metal base sample 22 and the counter electrode 23 from the direct current power source 24.
Experimental Example 2: At the same time the pressure inside the pressure-resistant electroplating chamber 11 became 10 MPa, an electroplating voltage was applied between the metal base sample 22 and the counter electrode 23 from the direct current power source 24.
Experimental Example 3: At the same time the pressure inside the pressure-resistant electroplating chamber 11 began rising, an electroplating was applied between the metal base sample 22 and the counter electrode 23 voltage from the direct current power source 24.

The results are described in Table 1 below.

**[Table 1]**

| | Voltage application time | Plating state |
|---|---|---|
| Experimental Example 1 | Five minutes after pressurization | Dissolution |
| Experimental Example 2 | Immediately after pressurization | Partial plating |
| Experimental Example 3 | At same time pressure starts rising | Nonuniform plating layer formed |

Namely, under the conditions in Experimental Example 1, the metal base sample 22 comprising a thin copper film was completely dissolved before the plating voltage was applied, and no copper plating film was obtained. Under the conditions in Experimental Example 2, a sizable portion of the metal base sample 22 comprising a thin copper film was dissolved, but the partially remaining portion was electroplated. Also, under the conditions in Experimental Example 3, a film was obtained, but the film was nonuniform and irregular.

The above experiment results indicate that a good electroplating film could not be obtained because the reaction between the electroplating solution and the metal base comprising a thin copper film proceeded too rapidly when a commonly employed high-throw bath was used to electroplate copper onto a metal base composed of copper in a supercritical state or a subcritical state.

### [Experimental Example 4]

Thus, in Experimental Example 4, the electroplating state was investigated under conditions in which a high-throw bath was used and noncritical pressure was applied. Namely, 40 mL of the high-throw bath was injected into the pressure-resistant electroplating chamber 11 as the electroplating solution, and the electroplating solution 19 in the pressure-resistant electroplating chamber 11 was heated to a temperature of 40°C. Next, using the metal base sample 22 comprising a thin copper film similar to the one described above, the metal base sample 22 comprising a thin copper film was arranged so as to be immersed into the electroplating solution 19.

In this state, the electroplating solution 19 was not stirred by the stirrer 20, and the carbon dioxide cylinder 12, the high-pressure pump unit 13, the valve 14, and the pressure adjustment unit 18 were operated to increase the pressure inside the pressure-resistant electroplating chamber 11 to 5 MPa. The electroplating solution 19 was stirred by the stirrer 20 at the same time as the pressure inside the pressure-resistant electroplating chamber 11 reached 5 MPa, and the electroplating voltage was applied from the direct current power source 24 to between the metal base sample 22 and the counter electrode 23.

In a state pressurized to 5 MPa, the critical condition is not achieved at 40°C, and the high-throw bath is therefore in a liquid state. Even in this case, a large portion of the metal base comprising a thin copper film dissolved before the direct current voltage was applied, and the electroplated film was obtained only partially.

### [Experimental Example 5]

Because the results of Experimental Examples 1 through 4 showed that a metal base composed of copper rapidly dissolved in a high-throw bath, which is an electroplating solution for copper applications, the composition of the electroplating solution was investigated further. Namely, sulfuric acid and chlorine ions were added to the high-throw bath for stabilization purposes. Thus, an experiment was conducted as Experimental Example 5 by using an electroplating solution having a composition such as the one described below in which sulfuric acid and chlorine ions were excluded in order to reduce the dissolution rate of the metal based composed of copper. The surfactant was the same as the one described above.

### Electroplating solution composition

| | |
|---|---|
| Copper sulfate (CuSo₄ • 5H₂O) | 70 g/L |
| Sulfuric acid (H₂SO₄) | 0 g/L |
| Chlorine ions (Cl⁻) | 0 mg/L |
| Nonionic surfactant | 10 mL/L |

Using the electroplating apparatus 10 shown in FIG. 1, 40 mL of an electroplating solution having the abovementioned composition was injected into the pressure-resistant electroplating chamber 11, and the electroplating solution in the pressure-resistant electroplating chamber 11 was heated to a temperature of 40°C. Next, using the same metal base sample 22 comprising a thin copper film as the one used in Experimental Examples 1 through 4, the metal base sample 22 was arranged so as to be immersed into the electroplating solution 19. In this state, the electroplating solution 19 was stirred by the stirrer 20 under atmospheric pressure without the application of any particular pressure, and an electroplating voltage was applied between the metal base sample 22 and the counter electrode 23 from the direct current power source 24.

In Experimental Example 5, some of the thin copper film had eluted from the metal base sample 22, and a plated film was obtained only partially. Thus, it was confirmed that elution of the thin copper film occurred even when sulfuric acid and chlorine ions were excluded from the conventional copper electroplating solution, and that electroplating could not be conducted in the regular manner.

### [Experimental Example 6]

The results from Experimental Examples 1 through 5 showed that reducing the rate at which copper dissolves in the electroplating solution for copper applications was necessary in order to electroplate copper on a metal base composed of copper. Thus, the rate at which copper dissolves in a copper electroplating solution was investigated as Experimental Example 6. First, a 2 cm × 2 cm × 5 mm electrolytic copper sample was provided, 40 mL of the copper electroplating solution comprising a high-throw bath used in Experimental Examples 1 through 4 was injected into the pressure-resistant electroplating chamber 11, this electrolytic copper sample was immersed into the copper electroplating solution 19, and the dissolution rate under one atmosphere of pressure at 60°C was investigated. The amount of copper dissolved from the electrolytic copper sample was evaluated by conducting a weight measurement. FIG. 2 shows the relationship between the amount of copper dissolved and the elapsed time.

The results in FIG. 2 show that because the copper concentration in the high-throw bath did not reach saturation concentration even after 31 hours elapsed, considerable time was required for the copper concentration in the copper electroplating solution to reach saturation when bulk copper was used.

Thus, solubility was investigated when copper powder was further added to the copper electroplating solution used in Experimental Examples 1 through 4. An electroplating solution in which the copper powder was present in a dispersed state was obtained when 300-mesh undersize was used as the copper powder, and 0.3 g was added under stirring to 500 mL of the high-throw bath. It was thus found that adding copper in a powdered state is preferred for bringing copper to a saturated state in a conventionally used electroplating solution for copper applications.

### [Experimental Examples 7 through 10]

The solubility of a metal base sample similar to the one used in Experimental Example 1 through 5 described above was subsequently investigated when the sample was immersed in a variety of copper electroplating solutions under atmospheric pressure at 25°C. The four types described in Experimental Examples 7 through 10 below were used as the copper electroplating solutions. The ratio in which copper powder was added in Experimental Examples 9 and 10 was such that 0.3 g of 300-mesh undersize was added under stirring to 500 mL of the high-throw bath in the same manner as in Experimental Example 6. The surfactant used in Experimental Example 10 was the same as the one added to the high-throw bath, and was directly added into the pressure-resistant electroplating chamber 11.
Experimental Example 7: High-throw bath
Experimental Example 8: High-throw bath + electrolytic copper dissolved for 31 hours (from Experimental Example 6)
Experimental Example 9: High-throw bath + copper powder
Experimental Example 10: 0.4 mL of a nonionic surfactant further added to the one in Experimental Example 9

40 mL of each of the four types of copper electroplating solution described above was injected into the pressure-resistant electroplating chamber 11, a metal base sample was immersed into these four types of copper electroplating solution under atmospheric pressure at 25°C, and each surface state was investigated after 3, 5, 10, 12, and 15 minutes had elapsed. The results are summarized in Table 2 below. In the results shown in Table 2, ○ indicates that no dissolution was found to have occurred at the copper surface, Δ indicates that a dissolution state was found to be present at the copper surface, and × indicates that the copper was completely dissolved.

**[Table 2]**

| | Composition | Elapsed Time | | | | |
|---|---|---|---|---|---|---|
| | | 3 min | 5 min | 10 min | 12 min | 15 min |
| Experimental Example 7 | High-throw bath | × | | | | |
| Experimental Example 8 | High-throw bath + electrolytic copper | × | | | | |
| Experimental Example 9 | High-throw bath + copper powder | ○ | ○ | △ | △ | × |
| Experimental Example 10 | Experimental Example 9 + nonionic surfactant | ○ | ○ | ○ | ○ | △ |

| | | | | | | |
|---|---|---|---|---|---|---|
| Key) ○: No change; △: Surface dissolution; ×: Total dissolution | | | | | | |

The results in Table 2 confirmed that elution of a metal base composed of copper could not be suppressed when bulk electrolytic copper had been dissolved in a high-throw bath in advance, but elution of a metal base composed of copper could be suppressed when copper metal powder was added and dispersed in a powdered state. The results also confirmed that elution of a metal base composed of copper could be suppressed further when an extra amount of surfactant was added.

### [Experimental Examples 11 and 12]

It is apparent from the results in Table 2 that elution of a metal base composed of copper can be further suppressed when a copper electroplating solution is used in a state in which copper metal powder is added and dispersed in a powdered state, and an extra amount of surfactant is added. Therefore, the variation in the state in which copper is eluted from the metal base was investigated for a case in which the electroplating solution from Experimental Example 10 was used, and the voltage applied between the metal base sample and the counter electrode was varied relative to a metal base sample similar to the one used in Experimental Examples 1 through 5.

Namely, no voltage was applied in Experimental Example 11, a voltage of 1 V was applied in Experimental Example 12, a voltage of 5 V was applied in Experimental Example 12, the electroplating solution was used in an amount of 40 mL, the temperature of the electroplating solution was set to 40°C, and the operation was conducted under stirring in all cases. 1 V is a voltage that is believed, theoretically, not to cause any copper plating or dissolution of copper.

The results are summarized in Table 3 below. In Table 3, ○ indicates that a copper plating film having a normal visual appearance was formed; △ indicates that a plating film was formed, but the film had irregularities; and × indicates that all copper had dissolved.

**[Table 3]**

| | Composition | Voltage | Current | Elapsed time | | |
|---|---|---|---|---|---|---|
| | | (V) | (mA) | 3 min | 5 min | 10 min |
| Experimental Example 11 | High-throw bath + Copper powder + Nonionic surfactant | - | - | △ | × | |
| Experimental Example 12 | | 1 | 30 | △ | × | |
| Experimental Example 13 | | 5 | 30 | ○ | ○ | ○ |

| | | | | | | |
|---|---|---|---|---|---|---|
| Key) ○: Was electroplated; △: Irregularities present; ×: Total dissolution | | | | | | |

It can be seen from the results in Table 3 that applying the voltage necessary for electroplating (5 V in this case) before immersing the metal base into the electroplating solution is preferred for the copper plating of a metal base composed of copper by using an electroplating bath to which a large amount of surfactant has been added and in which copper powder has been added to a high-throw bath and brought into a suspended state.

### [Experimental Example 14]

In Experimental Example 14, the conditions of Experimental Example 13 that had yielded the best results shown in Table 3 were adopted, the electroplating apparatus 10 shown in FIG. 1 was used, and electroplating was carried out under supercritical conditions. Copper powder was added to a high-throw bath and brought to a suspended state in a manner similar to Experimental Example 13. 30 mL of this copper electroplating solution was injected into the pressure-resistant electroplating chamber 11, and 0.3 mL of a nonionic surfactant was further added thereto.

Next, a base obtained by forming a thin copper film having a thickness of 65 nm on a 2 cm × 2 cm TaN substrate by sputtering was used as the metal base sample 22. This metal base sample 22 was pretreated by acid pickling and then placed together with the counter electrode 23 in the upper part of the electroplating solution 19 in the pressure-resistant plating chamber 11 to as not to be in contact with the electroplating solution 19. The amount of the electroplating solution 19 used was set at 30 mL. Next, a metal base sample 22 similar to the one used in Experimental Examples 1 through 5 was pretreated by acid pickling and then placed together with the counter electrode 23 in the upper part of the electroplating solution 19 in the pressure-resistant plating chamber 11 to as not to be in contact with the electroplating solution 19.

In this state, the electroplating solution in the pressure-resistant electroplating chamber 11 was heated to a temperature of 40°C; a voltage of 5 V was applied between the metal base sample 22 and the counter electrode 23; and the carbon dioxide cylinder 12, the high-pressure pump unit 13, the valve 14, and the pressure adjustment unit 18 were operated to increase the pressure inside the pressure-resistant electroplating chamber 11 to 10 MPa without initially stirring the electroplating solution 19 with the stirrer 20. The electroplating solution 19 was stirred by the stirrer 20 at the same time as the pressure inside the pressure-resistant electroplating chamber 11 reached 10 MPa.

By maintaining this state for three minutes and operating the pressure adjustment unit 18 while applying a voltage of 5 V between the metal base sample 22 and the counter electrode 23, the carbon dioxide in the pressure-resistant electroplating chamber 11 was gradually released to reduce the pressure to atmospheric pressure. A good copper plating film was formed on the surface of the resulting metal base sample 22. Consequently, it became clear that a Damascene method or a dual Damascene method based on the use of a supercritical fluid could also be applied according to the operating conditions employed in Experimental Example 14.

Although 300-mesh undersize was used as copper powder in the experimental examples described above, a smaller particle diameter is preferred in order to increase the dissolution rate because the purpose of the copper powder is to keep the copper concentration in the electroplating solution substantially at a saturation concentration. In particular, because copper disperses well and aggregates less readily in the electrolytic solution when particles smaller than 1 µm are used, electroplating can also easily be performed on substrate structures whose precision is less than 1 µm. Obtaining fine metal powder in which the metal has an average particle diameter of less than 1 nm is difficult at the present time, but an average particle diameter of about 1 nm is realistic.

The above experimental examples described cases in which the metal used in both the metal base and the electroplating metal was copper, but the electroplating method of the present invention has the same effect with any other metal base and electroplating metal as long as they are of the same type. Not only copper but also zinc, iron, nickel, cobalt, and the like are equally applicable as the metal base and electroplating metal.

## Claims

1. A method for electroplating the surface of a metal base, the method **characterized in** comprising: performing electroplating by utilizing an induction codeposition phenomenon in a supercritical or a subcritical state using at least one of carbon dioxide and an inert gas, as well as an electroplating solution containing a metal powder dispersed therein, and a surfactant.

2. The electroplating method according to claim 1, **characterized in that** said metal powder comprises the same metal as at least one of the metal base and a metal film obtained in electroplating.

3. The electroplating method according to claim 1, **characterized in that** the average particle diameter of said metal powder is from 1 µm or greater to 100 µm or less.

4. The electroplating method according to claim 1, **characterized in that** the average particle diameter of said metal powder is from 1 nm or greater to less than 1 µm.

5. The electroplating method according to claim 1, **characterized in that** a voltage at which said metal base does not dissolve is applied before said metal base is immersed into said electroplating solution.

6. The electroplating method according to claim 5, **characterized in that** the voltage at which said metal base does not dissolve is the voltage used during electroplating.
